# EUROPEAN PATENT SPECIFICATION

(11) **EP 1 476 249 B1**
(45) Date of publication and mention of the grant of the patent: **30.08.2006**
(21) Application number: 02789868.3
(22) Date of filing: 22.11.2002
(51) Int. Cl.: B01J 3/00, B01J 3/04, B01J 3/06, B01J 19/00, B01J 19/02

(54) **IMPROVED PRESSURE VESSEL**
VERBESSERTER DRUCKVESSEL
APPAREIL A PRESSION AMELIOREE

(30) Priority: 31.01.2002 US 683658
(43) Date of publication of application: 17.11.2004
(73) Proprietor: GENERAL ELECTRIC COMPANY, Schenectady, NY 12345 (US)
(72) Inventor: D'EVELYN, Mark, Philip, Niskayuna, NY 12309 (US); NARANG, Kristi, jean, Voorheesville, NY 12186 (US); GIDDINGS, Robert, Arthur, Slingerlands, NY 12159 (US); LEONELLI, Robert, Vincent, Jr., Solon, OH 44139 (US); DOLE, Stephan, Lee, Columbus, OH 43229 (US)
(74) Representative: Pedder, James Cuthbert
(86) International application number: PCT/US2002/037755
(87) International publication number: WO 2003/064021

(56) References cited:
- WO-A-02/34972
- DE-A- 4 413 423
- FR-A- 1 275 127
- GB-A- 2 333 521
- US-A1- 2002 122 757
- PATENT ABSTRACTS OF JAPAN vol. 009, no. 235 (M-415), 21 September 1985 (1985-09-21) & JP 60 091062 A (KOBE SEIKOSHO KK), 22 May 1985 (1985-05-22)
- PATENT ABSTRACTS OF JAPAN vol. 1997, no. 12, 25 December 1997 (1997-12-25) & JP 09 206582 A (DENKI KAGAKU KOGYO KK), 12 August 1997 (1997-08-12)
- PATENT ABSTRACTS OF JAPAN vol. 1998, no. 05, 30 April 1998 (1998-04-30) & JP 10 005572 A (SUMITOMO ELECTRIC IND LTD), 13 January 1998 (1998-01-13)

## Description

### BACKGROUND OF INVENTION

The invention relates generally to pressure vessels. More particularly, the present invention relates to an improved pressure vessel for processing at least one material in a supercritical fluid.

Many chemical or material synthesis processes can best be run at elevated pressures and temperatures within a vessel or cell containing either a solid, liquid, or gaseous medium. Well-known cell designs, such as those employed in commercial synthetic diamond manufacturing, can be used when the medium is a solid at room temperature. When the medium is a liquid or a gas at room temperature, reactions can be carried out at pressures of up to a few kilobar (kbar) in autoclaves. No suitable autoclave design is currently available, however, for processing in a medium other than an inert gas and at pressures exceeding more than a few kilobar.

In instances where even higher pressures are needed, reactants and solvent are sealed within a capsule and then subjected to an external pressure supplied by a press, such as a piston cylinder press, a belt-type uniaxial press, or a multi-anvil press. If the externally applied pressure is insufficient, the capsule will burst. Conversely, if the external pressure is too great, the capsule will be crushed. In both instances, reactant and solvent are released from the capsule and infiltrate into the pressurized cell or vessel.

Present methods of processing materials under high pressure, high temperature conditions generally employ capsules that are filled with reactants and solvents and subsequently sealed. The filling operation is usually carried out under ambient conditions, as generally applicable methods for excluding air from the capsule are not available. Consequently, the process may be subject to contamination by air introduced into the capsule during the filling process.

Materials cannot be processed under high pressure, high temperature conditions in a substantially air-free environment. Therefore, what is needed is an improved pressure vessel in which materials can be processed under high pressure, high temperature conditions. More particularly, what is needed is a pressure vessel in which materials can be processed with a liquid, gas, or supercritical fluid where the process pressure exceeds a few kilobar. What is also needed is a pressure vessel in which materials can be processed in an air-free environment under high pressure, high temperature conditions.

### SUMMARY OF INVENTION

The present invention meets these and other needs by providing a pressure vessel for reacting at least one material with a supercritical fluid in a substantially air-free environment under high pressure, high temperature conditions. The apparatus also includes a self-pressurizing vessel in which the reaction takes place and is relatively insensitive to the actual process pressure. The present invention also includes methods of using the pressure vessel and processing a material at high temperature and high pressure in the presence of a supercritical fluid within the pressure vessel.

According to a first aspect of the invention, there is provided a pressure vessel for processing at least one material in a supercritical fluid, said pressure vessel comprising:
(a) a capsule for containing said at least one material and said supercritical fluid in a substantially air-free environment, said capsule being self-pressurizing;
(b) a pressure transmission medium for maintaining an outer pressure on said capsule, said pressure transmission medium surrounding said capsule;
(c) a heating system for heating said capsule, said heating system comprising at least one heating element insertable in said pressure transmission medium such that said at least one heating element is proximate to said capsule and a wattage control system electrically coupled to said at least one heating element, wherein said wattage control system provides power to said at least one heating element;
(d) a restraint to contain and hold in place said capsule, said pressure transmission medium, and said at least one heating element, wherein said restraint maintains said capsule, said pressure transmission medium, and said at least one heating element at a constant pressure; and
(e) at least one seal for preventing escape of said pressure transmission medium, said at least one seal being disposed between said restraint and said pressure transmission medium.

The heating system may further comprise at least one temperature sensor disposed proximate to said capsule for measuring a temperature of said capsule.

The capsule may be formed from a malleable metal, and may have a low hydrogen permeability.

The capsule of the pressure vessel may further comprise at least one wall, a closed end, and a sealed end defining a chamber therein for containing said at least one material and said supercritical fluid, and the heating system may comprise at least one temperature sensor disposed proximate to said capsule for measuring a temperature of said capsule, the wattage control system being electrically connected to said at least one heating element and said at least one temperature sensor.

The at least one heating element may be an electrically resistant heating element comprising one of at least one foil, at least one tube, at least one ribbon, at least one bar, and at least one wire, and combinations thereof.

According to a second aspect of the invention, there is provided a method of processing at least one material at high temperature and high pressure in the presence of a supercritical fluid, the method comprising the steps of:
(a) providing a sealed capsule containing the at least one material and a solvent that forms a supercritical fluid, wherein the capsule is self-pressurizing;
(b) providing a pressure vessel comprising a restraint, a pressure transmission medium disposed within the restraint, and at least one heating element (18) disposed within the restraint;
(c) disposing the sealed capsule within the pressure transmission medium such that the sealed capsule is proximate to the at least one heating element;
(d) heating the sealed capsule to a predetermined temperature by providing electrical power to the at least one heating element, wherein the solvent contained within the sealed capsule becomes a supercritical fluid and wherein the supercritical fluid generates a predetermined pressure within the sealed capsule; and
(e) counterbalancing the predetermined pressure within the sealed capsule by applying a pressure to the restraint, wherein the at least one material reacts with the supercritical fluid within the sealed capsule.

The at least one heating element may be electrically coupled to a wattage control system and the method may comprise the further steps of
placing the pressure vessel containing the pressure transmission medium, the sealed capsule, and the at least one heating element in a press;
pressurizing the press to apply a predetermined pressure to the pressure vessel, the pressure transmission medium, the sealed capsule and the at least one heating element; and
wherein step (d) may further comprise the step of providing electrical power from the wattage control system to the at least one heating element; and wherein in step (e) pressure may be applied by maintaining an equivalent pressure with the restraint and transmitting the equivalent pressure through the pressure transmission medium.

The restraint may comprise at least one die, at least one punch, and a hydraulic press, and wherein the pressure transmission medium and the at least one heating element are disposed within the die; and wherein the step, of disposing the sealed capsule within the pressure vessel comprises disposing the sealed capsule within the die such that the sealed capsule is proximate to the at least one heating element.

According to a third aspect of the invention, there is provided a method for making a metal nitride single crystal comprising the steps of enclosing a metal nitride source material and a solvent within a sealed capsule that is self-pressurizing; disposing the sealed capsule within a pressure vessel comprising a restraint, a pressure transmission medium disposed within the restraint, and at least one heating element disposed within the restraint; heating the sealed capsule to a predetermined temperature, wherein the solvent contained within the sealed capsule becomes a supercritical fluid and generates a predetermined pressure within the sealed capsule; and counterbalancing the predetermined pressure within the sealed capsule by applying a pressure to the restraint; wherein the metal nitride source material reacts with the supercritical fluid within the sealed capsule to form a metal nitride single crystal at high temperature and high pressure.

These and other aspects, advantages, and salient features of the present invention will become apparent from the following detailed description, the accompanying drawings, and the appended claims.

### BRIED DESCRIPTION OF DRAWINGS

FIGURE 1 is a schematic representation of a pressure vessel assembly of the present invention in which the restraint comprises a hydraulic press with a pair of punches and a die;
FIGURE 2 is a schematic representation of a capsule in accordance with one embodiment of the instant invention;
FIGURE 3 is a schematic representation of a pressure vessel of the present invention in which the restraint comprises a multi-anvil press; and
FIGURE 4 is a schematic representation of a pressure vessel of the present invention in which the restraint comprises a die and reinforced end flanges.

### DETAILED DESCRIPTION

In the following description, like reference characters designate like or corresponding parts throughout the several views shown in the figures. It is also understood that terms such as "top," "bottom," "outward," "inward," and the like are words of convenience and are not to be construed as limiting terms.

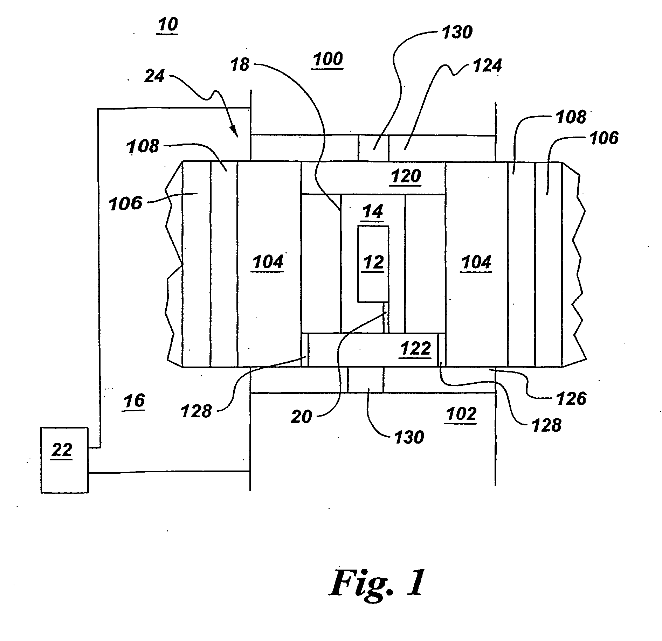

Referring to the drawings in general and to Figure 1 in particular, it will be understood that the illustrations are for the purpose of describing a preferred embodiment of the invention and are not intended to limit the invention thereto. Pressure vessel tooling (also referred to herein as "pressure vessel") 10 for processing at least one material in a supercritical fluid is shown in Figure 1. Pressure vessel 10 comprises a cell. A sealed, self-pressurizing capsule 12 for containing the at least one material and a solvent is disposed within the cell. The solvent becomes a supercritical fluid at high temperature and high pressure (also referred to herein as "HPHT"). HPHT conditions encompass temperatures greater than about 100°C and pressures greater than about 1 atm. A pressure transmission medium 14 disposed in the cell surrounds the self-pressurizing capsule 12 and maintains an outer pressure on the self-pressurizing capsule 12 to prevent the self-pressurizing capsule 12 from rupturing or bursting. The high pressure necessary for processing the at least one material is generated within the self-pressurizing capsule 12 itself, rather than the necessary pressure being externally applied to the capsule. As the capsule is heated, the vapor pressure of the solvent increases. The vapor pressure of the solvent at a given temperature and quantity of solvent present (also known as "percent fill") within the capsule can be determined from the phase diagram of the solvent. At a sufficiently high temperature and pressure, the solvent becomes a supercritical fluid. As the internal pressure within the self-pressurizing capsule 12 increases, the walls of the self-pressurizing capsule 12 deform outward and press against pressure transmission medium 14.

Pressure transmission medium 14 is thermally stable up to the temperature at which the at least one material is to be processed in a supercritical fluid. That is, pressure transmission medium 14 does not decompose or react with the other components of pressure vessel 10, or undergo a solid state phase transition. Pressure transmission medium 14 preferably remains a solid at the processing temperature and has a relatively low shear strength and internal friction. For example, the internal friction is below about 0.2. It is desirable that the pressure transmission medium 14, when placed in the cell of pressure vessel 10, be compacted to greater than about 85% of its theoretical density in order to avoid introducing excess porosity into the cell. Pressure transmission medium 14 is preferably a solid up to about 1000°C and, more preferably, up to about 1300°C. In one embodiment, pressure transmission medium 14 comprises at least one alkali halide, such as NaCl, NaBr, or NaF. Sodium chloride performs particularly well at temperatures approaching its melting point, which, at pressures of about 10 to about 20 kbar, is between about 1000°C and about 1150°C.

Alternatively, pressure transmission medium 14 may comprise at least one of talc, pyrophyllite, molybdenum disulfide, graphite, hexagonal boron nitride, silver chloride, calcium fluoride, strontium fluoride, calcium carbonate, magnesium oxide, zirconium oxide, merylinite clay, bentonite clays, and sodium silicate.

At least one heating element 18 is disposed within the cell and proximate to the self-pressurizing capsule 12. The at least one heating element 18 comprises at least one of graphite, nichrome, niobium, titanium, tantalum, stainless steel, nickel, chromium, zirconium, molybdenum, tungsten, rhenium, hafnium, platinum, silicon carbide, and combinations thereof. The at least one heating element 18 may take the form of at least one resistively heated tube, foil, ribbon, bar, wire, or combinations thereof.

A wattage control system 16 is electrically connected to the at least one heating element 18 to provide power for heating the self-pressurizing capsule 12. Additionally, wattage control system 16 may either directly or indirectly control the temperature of the self-pressurizing capsule 12. In one embodiment, the wattage control system 16 includes a controller 22 for powering and controlling the at least one heating element 18. Controller 22 preferably provides closed-loop control of the heating power. In one embodiment, the wattage control system 16 includes at least one temperature sensor 20 for generating temperature signals associated with the self-pressurizing capsule 12. In another embodiment, the power controller provides closed-loop temperature control in response to the temperature signals generated from the temperature sensor 20. In one embodiment, the at least one temperature sensor 20 is situated proximate to, and, preferably, in direct contact with the self-pressurizing capsule. Temperature sensor 20 may include at least one of a thermocouple, thermistor, an optical fiber coupled to an optical pyrometer, or any combination thereof.

For some types of supercritical fluid processing at high pressure and high temperature, an isothermal cell is desired. In other applications, however, a temperature gradient between two ends of the self-pressurizing capsule 12 is desired. For example, crystal growth is among those applications in which a temperature gradient is sometimes desirable. In one embodiment, the temperature gradient may be achieved by placing the self-pressurizing capsule 12 closer to one end of the cell than the other. Alternatively, the temperature gradient is produced by providing at least one heating element 18 having a non-uniform resistivity along its length. Non-uniform resistivity of the at least one heating element 18 may be provided, for example, by providing at least one heating element 18 having a non-uniform thickness, by perforating the at least one heating element 18 at selected points, or by providing at least one heating element 18 that comprises a laminate of at least two materials of differing resistivity at selected points along the length of the at least one heating element 18. In one embodiment, at least two independent temperature sensors are provided to measure and control the temperature gradient between the opposite ends of the self-pressurizing capsule 12. In one embodiment, closed-loop temperature control is provided for at least two locations within the cell. The at least one heating element 18 may also comprise multiple zones which may be individually powered to achieve the desired temperature gradient between two ends of the self-pressurizing capsule 12.

A restraint 24 is positioned so as to apply a compensating pressure to the external surface of the pressure transmission medium 14 to contain and hold in place (i.e., maintain the relative positions) and prevent shifting of the self-pressurizing capsule 12, the pressure transmission medium 14, the at least one heating element 18, and, additionally, the temperature sensor 20, with respect to each other during processing.

Restraint 24 also serves to prevent bursting of the self-pressurizing capsule 12 by counterbalancing the pressure generated within the self-pressurizing capsule 12 at high temperature. The individual component parts, namely the pressure transmission medium 14 and the capsule 12, are maintained in position relative to each other during the process by restraint 24. Restraint 24 exerts an external pressure on self-pressurizing capsule 12 of less than about than about 1 kbar at ambient temperature.

The self-pressurizing capsule 12 is self-pressurizable up to between about 1 atm (=1 bar) and about 80 kbar. In one embodiment, self-pressurizing capsule 12 is pressurizable up to between about 5 kbar and about 80 kilobar. In another embodiment, self-pressurizing capsule 12 is pressurizable up to between about 5 kbar and about 60 kilobar. The self-pressurizing capsule 12 is typically fornied from a malleable metal such as, but not limited to, copper, silver, gold, platinum, stainless steel or the like. Additionally, self-pressurizing capsule 12 typically has low hydrogen permeability and is chemically inert with respect to the supercritical fluid and the material to be processed within the self pressurizing capsule 12.

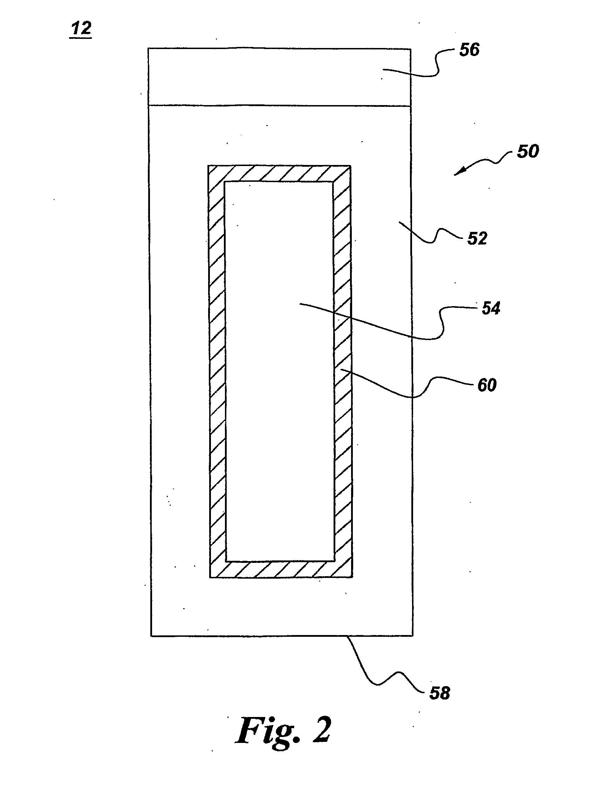

In one embodiment of the invention, self-pressurizing capsule 12 comprises an annular housing 50 having a wall 52 defining an inner cavity or chamber 54, a closed end 58 and a sealed end 56, as shown in Figure 2. Typically, outer wall 52, closed end 58 and sealed end 56 each have a thickness in the range between about 0.5 mm to about 25 mm. Sealed end 56 is formed after introducing at least one material to be processed under HPHT conditions and the solvent into inner chamber 54. Sealed end 56 is formed while maintaining inner chamber 54 under vacuum or under an atmosphere comprising either solvent vapor, an inert gas, or combinations thereof. Self-pressurizing capsule 12 may also include a baffle (not shown) to divide inner chamber 54 into more than one section, in fluid communication with each other through through-holes located in the baffle. Thus, inner chamber 54, once sealed, provides an air-free environment for processing the at least one material in the presence of a supercritical fluid under HPHT conditions. Consequently, the at least one material can be processed with a reduced risk of contamination.

In another embodiment, the self-pressurizing capsule 12 includes an inert liner 60, which is slidingly inserted into inner cavity 54 prior to introducing the at least one material and solvent into the self-pressurizing capsule 12. Inert liner 60 serves as an additional barrier to prevent or minimize chemical attack of the self-pressurizing capsule by the at least one material, solvent, or supercritical fluid. Inert liner 60 typically has a thickness of between about 1 micron and about 5 mm. Inert liner 60 is formed from a material that is different from that of the self-pressurizing capsule 12 and comprises at least one of gold, platinum, rhodium, palladium, silver, iridium, ruthenium, silica, and combinations thereof.

The self-pressurizing capsule and methods of filling and sealing the self-pressurizing capsule are described in more detail in United States Patent Application No. 09/683,659, filed on January 31, 2002, by Mark Philip D'Evelyn, et al., entitled "High Temperature High Pressure Capsule for Processing Materials in Supercritical Fluids," which is incorporated herein by reference in its entirety.

As presented above, restraint 24 (Figure 1) is positioned so as to apply a counterbalancing or compensating pressure to the external surface of the pressure transmission medium 14 in order to contain and hold in place the self-pressurizing capsule 12 and pressure transmission medium 14. Restraint 24 can include any number of combined devices such as, but not limited to, hydraulic presses, plates, clamps, belts, dies, punches, anvils, pistons, or the like.

In one embodiment, restraint 24 includes a uniaxial hydraulic press (not shown), a pair of opposing punches (for example, top punch 100 and bottom punch 102), a die 104, and at least one compression ring 106. Preferably, top punch 100 and bottom punch 102 are flat-bottomed punches. Anvils may be substituted for the opposing punches. The at least one compression ring 106 is typically fabricated from hardened steel and serves to compress die 104 and permit greater internal pressures to be generated within self-pressurizing capsule 12 without failure of the die 104. A cooling sleeve 108 may be optionally positioned between the die 104 and the at least one compression ring 106 to provide efficient cooling of the die 104. The cooling sleeve 108 may contain at least one cooling channel through which a cooling medium is circulated. The cooling medium may be either a gas, such as argon, helium, nitrogen, or the like, or a liquid, such as, but not limited to, water, brine, mixtures of water and ethylene glycol, and the like. In operation, die 104 is surrounded by at least one compression ring 106 and placed on bottom punch 102. Instead of - or in addition to - being surrounded by compression ring 106, die 104 may be contained within at least one tension-wound steel wire, at least one steel ribbon, and combinations thereof. Die 104 is typically a straight-wall die that may be fabricated from a variety of materials including, but not limited to, cemented tungsten carbide and hardened steel. Alternatively, die 104 may have either an angled wall or a concave wall, with the center portion of the die 104 having a smaller inner diameter than the inner diameter near the ends of the die 104. Pressure transmission medium 14, which is typically sodium chloride (NaCl), is placed within die 104. In order to minimize chemical reactivity and friction between pressure transmission medium 14 and die 104, at least one liner or lubricant may be positioned between pressure transmission medium 14 and die 104. Suitable liner or lubricant materials include, but are not limited to, lead foil, gold, silver, copper, talc, pyrophyllite, molybdenum disulfide, graphite, hexagonal boron nitride, silver chloride, calcium carbonate, magnesium oxide, zirconium oxide, merylinite clays, bentonite clays, and sodium silicate. The at least one heating element 18 and at least one temperature sensor 20 are next inserted in the pressure transmission medium 14. Self-pressurizing capsule 12, containing at least one reactant and a solvent that becomes a supercritical fluid at high temperature and high pressure, is inserted into pressure transmission medium 14. Finally, top punch 102 is placed on top of the die to close the pressure vessel tooling 10.

Once assembled, the pressure vessel tooling 10 is moved into a uniaxial hydraulic press, where pressure is applied onto opposing top and bottom punches 100, 102. The press can be loaded initially to full force. Alternatively, force can be applied to a predetermined level, or to obtain a selected stroke in order to densify the components, such as the pressure transmission medium 14, top gasket 124, and bottom gasket 126, and to seal pressure vessel 10. Additional force is then applied as the self-pressurizing capsule 12 is heated, in order to keep the press from stroking (i.e., changing the displaced position of top and bottom punches 100 and 102), thus maintaining top and bottom punches 100 and 102 in a fixed or constant position. At lower temperatures, only a modest internal pressure (for example, less than about 1 kbar) is present within the self-pressurizing capsule 12, and virtually the entire punch load is imposed onto the die 104. The self-pressuiizing capsule 12 is heated, for example, by passing electrical current between top and bottom punches 100 and 102 and through heating element 18. As the self-pressurizing capsule 12 is heated, the solvent initially vaporizes and, with increasing temperature, becomes a supercritical fluid. The internal pressure correspondingly builds up within the self-pressurizing capsule 12. The actual amount of internal pressure generated within self-pressurizing capsule 12 at a given temperature can be determined by the phase diagram of the solvent that is selected for processing the at least one material. The self-pressurizing capsule 12 deforms outward, loading the pressure transmission medium 14 and, in turn, exerting pressure against the underside of top punch 100 and the top of bottom punch 102. As the internal pressure within the capsule and pressure transmission medium increases, an increasing fraction of the punch load counterbalances or compensates for the internal pressure. However, a significant fraction (i.e., at least about 30%) of the punch load remains on the die 104 so as to reduce longitudinal or axial stresses in die 104.

The performance of an HPHT apparatus may be characterized by its pressure response, which is defined as the percent increase in cell pressure divided by the percent increase in press force that produces the increased cell pressure, relative to a reference operating condition. In conventional HPHT devices, the pressure response is typically high, ranging from near unity for piston cylinder presses to about 50% for belt-type presses and multi-anvil presses. Under such circumstances, precise control of the pressure applied to the capsule via the press force is required in order to prevent the capsule from either bursting or being crushed.

In contrast to conventional HPHT devices, the pressure vessel tooling 10 of the present invention is a "zero stroke" apparatus, in which the pressure response is below 0.2, and, more preferably below, 0.05. A zero stroke apparatus is much easier to control in supercritical-fluid-processing applications, and is able to capture or contain the pressure generated within the capsule with little or no tendency to crush it. Although some stroking (e.g., an increase or decrease in the separation between the punches or anvils) may occur during operation, the extent of stroking is much smaller than in previous designs.

Because of the geometry of the pressure vessel tooling 10 of the present invention, an increase in load on the punches is almost completely borne by the die 104, and the increase in cell pressure is very small. The resulting pressure response value of pressure vessel tooling 10 is below 0.2 and, most likely below 0.05, during operation.

In one embodiment, a top seal 120 and bottom seal 122 are interposed between the top and bottom punches 100, 102, respectively, and the pressure transmission medium 14 to prevent escape of the pressure transmission medium 14. Top and bottom seals 120, 122 typically comprise steel end caps, which are optionally fitted with a ring fabricated from brass or another similarly defoumable material. At least one of top and bottom seals 120, 122 is separated from contact with die 104 by a bushing 128 to prevent creation of an electrical short between the die 104 and either the at least one heating element 18 or the electrical leads connecting the at least one heating element 18 to the wattage source. The insulating bushing preferably has an internal friction between about 0.2 and about 0.7 under operating conditions, or, more preferably, between about 0.25 and about 0.5. The insulating bushing comprises at least one of pyrophyllite, talc, olivine, magnesium oxide, calcium carbonate, calcium oxide, strontium oxide, barium oxide, textilite and similar glued paper composites, merylinite clay, bentonite clay, sodium silicate, and hexagonal boron nitride.

Top gasket 124 and bottom gasket 126 are typically disposed between top punch 100 and die 104 and bottom punch 102 and die 104, respectively. Alternatively, top gasket 124 and bottom gasket 126 may also be disposed between top punch 100 and top seal 120 and bottom punch 102 and bottom seal 122, respectively. At least one of top gasket 124 and bottom gasket 126 is an electrical insulator, so that die 104 does not act as an electrical short for the at least one heating element 18. In one embodiment, the insulating gasket comprises at least one of natural or synthetic rubber, Mylar® (polyester film), polyimide, Teflon® (fluorocarbon polymer, tetrafluoroethylene fluorocarbons, fluorinated ethylene-propylene, and the like), pyrophyllite, talc, olivine, magnesium oxide, calcium carbonate, calcium oxide, strontium oxide, barium oxide, textilite and similar glued paper composites, merylinite clay, bentonite clay, sodium silicate, and hexagonal boron nitride. In one embodiment, a non-insulating, or electrically conductive, gasket comprises at least one of copper, brass, molybdenum, graphite, nickel, cobalt, iron, and stainless steel. In one embodiment in which top gasket 124 is disposed between top punch 100 and top seal 120 and bottom gasket 126 is disposed between bottom punch 102 and bottom seal 122, top gasket 124 and bottom gasket 126 are formed with a conductive element 130 within an insulating gasket element so that electrical current may pass from punch 100 to heating element 18 without die 104 acting as an electrical short. The conductive element may comprise at least one of molybdenum, graphite, tungsten, tantalum, niobium, copper, copper alloy, nickel, nickel alloy, iron, iron alloy, and the insulating gasket element comprises at least one of natural rubber, synthetic rubber, Mylar® (polyester film), polyimide, Teflon® (fluorocarbon polymer, tetrafluoroethylene fluorocarbons, fluorinated ethylene-propylene, and the like), pyrophyllite, talc, olivine, magnesium oxide, calcium carbonate, calcium oxide, strontium oxide, barium oxide, textilite and similar glued paper composites, merylinite clay, bentonite clay, sodium silicate, and hexagonal boron nitride. In one embodiment, top gasket 124 and bottom gasket 126 may also act as the seal to prevent escape of pressure transmission medium 14.

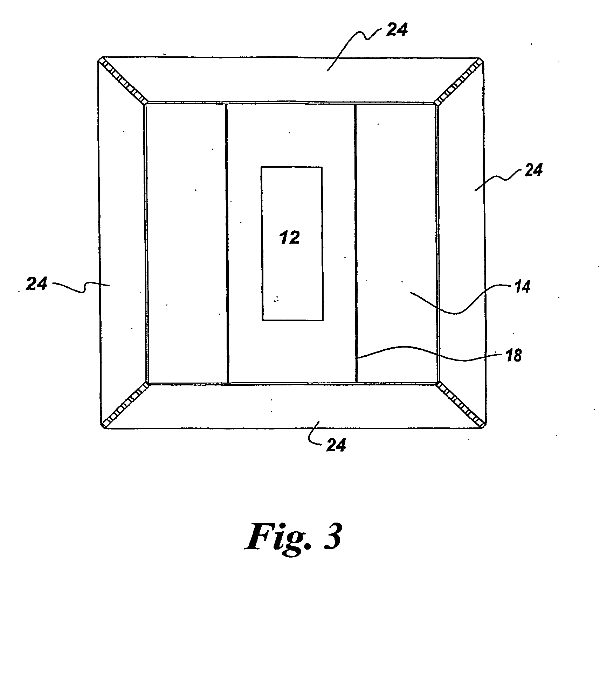

In another embodiment of the invention, shown in Figure 3, the restraint 24 comprises a multi-anvil press having at least four anvils. In this embodiment, the self-pressurizing capsule 12, pressure transmission medium 14, and at least one heating element 18 are configured in a fashion similar to that shown in Figure 1, but are instead inserted into a multi-anvil press having at least four anvils. The pressure transmission medium 14 is surrounded by support plates, which support the load exerted by the press when the capsule is at low temperature and low internal pressure. The support plates are separated from one another by gasket material, which is preferably electrically insulating. The gasket material comprises at least one of natural or synthetic rubber, Mylar® (polyester film), polyimide, Teflon® (fluorocarbon polyner, tetrafluoroethylene fluorocarbons, fluorinated ethylene-propylene, and the like), pyrophyllite, talc, olivine, magnesium oxide, calcium carbonate, calcium oxide, strontium oxide, barium oxide, textilite and similar glued paper composites, merylinite clay, bentonite clay, sodium silicate, and hexagonal boron nitride. External pressure may be applied to the support plates either by four or more independent anvils or pistons or by a multi-anvil assembly placed inside a uniaxial press, a split-sphere press, or other similar pressurizing apparatus known in the art. As the capsule is heated, internal pressure builds up within the self-pressurizing capsule 12, causing its walls to deform outward against the pressure transmission medium 14. As the pressure in the pressure transmission medium 14 builds up, an increasing fraction of the press force counterbalances - or compensates for - the internal pressure, and a decreasing fraction of the press force is supported by the support plates. Instead of producing a substantial increase in cell pressure, an increase in press force is largely borne by the support plates and the pressure response value is below 0.2.

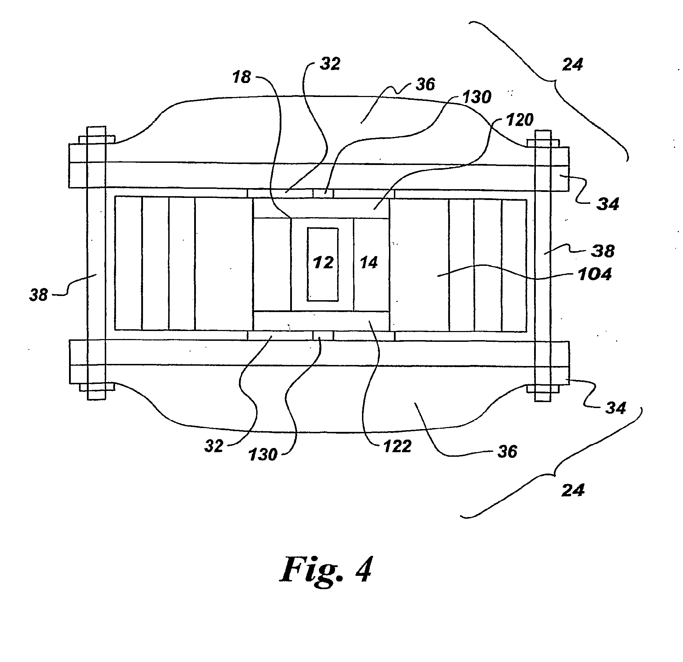

In yet another embodiment, shown in Figure 4, restraint 24 comprises a die and reinforced end flanges. The self-pressurizing capsule 12, pressure transmission medium 14, heater 18, top seal 120, bottom seal 122, and die 104 are surrounded by at least one restraint 24 and are configured in a fashion similar to that shown in Figure 1, but are instead enclosed by two end flanges 34, each of which is reinforced by an I-beam 36 or similar structural support. The die 104 is separated from the end flanges 34 by gaskets 32. In one embodiment, gaskets 32 contact the upper and lower surfaces of die 104 so as to contain and prevent leakage of pressure transmission medium 14 from die 104. At least one gasket 32 contains an electrically insulating portion to prevent creation of an electrical short between the die 104 and either the at least one heating element 18 or the electrical leads connecting heating element 18 to the wattage source. The insulating gasket material may comprise at least one of natural or synthetic rubber, Mylar® (polyester film), polyimide, Teflon® (fluorocarbon polymer, tetrafluoroethylene fluorocarbons, fluorinated ethylene-propylene, and the like), pyrophyllite, talc, olivine, magnesium oxide, calcium carbonate, calcium oxide, strontium oxide, barium oxide, textilite and similar glued paper composites, merylinite clay, bentonite clay, sodium silicate, and hexagonal boron nitride. At least one gasket 32 may be an electrically-conductive gasket, or include an electrically-conductive element 130 within an insulating gasket. The electrically conducting gasket or electrically conducting element 130 may comprise at least one of molybdenum, graphite, tungsten, tantalum, niobium, copper, copper alloy, nickel, nickel alloy, iron, and iron alloy. End flanges 34 are attached to one another or to the die assembly by fastening means 38. Such fastening means 38 include, but are not limited to, bolts, threaded rods, or similar fasteners. Tightening of fastening means 38 causes end 34 flanges to exert a compressive load on the die assembly. When the self-pressurizing capsule 12 is at low temperature and has a low internal pressure, the load of the end flanges 34 is supported almost entirely by the die 104 itself. As the self-pressurizing capsule 12 is heated, the internal pressure builds up inside the self-pressurizing capsule 12, causing its walls to deform outward against the pressure transmission medium 14. As the pressure in the pressure transmission medium 14 builds up, an increasing fraction of the load from the end flanges 34 counterbalances or compensates for the internal pressure within the self-pressurizing capsule 12, and a decreasing fraction of the load force is supported by the die 104.

The pressure vessel 10 may be used to form single crystals of materials such as, but not limited to, metal nitrides, including aluminum nitride, other nitride materials, and the like. To form such single crystals, at least one source material and a solvent that becomes a supercritical fluid under HPHT conditions are sealed within the self-pressurizing capsule 12. Self-pressurizing capsule 12 is then provided to the pressure vessel tooling 10 and subjected to HPHT conditions, under which the solvent becomes a supercritical fluid. The supercritical fluid then reacts with the at least one material to form single crystals.

The following example serves to illustrate the features and advantages offered by the present invention, and is not intended to limit the invention thereto.

### Example 1

Pressure vessel tooling for use in a 1000-ton hydraulic press was fabricated as follows. A cemented tungsten carbide die having an inner diameter of about 5.08 cm (2.0 inches), an outer diameter of 17.53 cm (6.9 inches), and a height of 9.4 cm (3.7 inches) was shrink-fitted into a steel die sleeve. The die sleeve contained eight axial cooling channels to provide for water cooling of the die. The die and die sleeve were pressed into a belt comprising three compression-fit steel rings having outer diameters of about 27.2 cm (10.7 inches), 37.3 cm (14.7 inches) and 48.3 cm (19 inches), respectively. The die, die sleeve, and steel compression rings had interferences so as to provide compression of the die. The belt assembly was then press-fitted into a fourth steel "guard" ring with an outer lip to permit lifting and transport. Brass rings with channels machined into the inner faces were attached to the top and bottom of the die sleeve, with the channels aligned with the axial cooling channels in the die sleeve so that water could be forced to flow through the channels in a serpentine fashion to provide cooling. Copper tubing was brazed to the upper brass ring in order to provide water flow into and out of the die sleeve. The anvil faces comprised cemented tungsten carbide disks, about 9.65 cm (3.8 inches) in diameter and about 2.54 cm (1.0 inch) thick, and were press fitted into steel sleeves and a steel holder. The diameter of the anvil holder was about 13.67 cm (5.38 inches) at the plane of the anvil face.

About 0.20 g of AlN powder and 0.10 g of NH₄F powder were pressed into two pills and placed in a capsule. One pill was placed in the bottom of the capsule, and a baffle was then inserted in the capsule to divide the interior of the capsule into two chambers. The second pill was then placed on top of the baffle such that the two pills were separated by the baffle. The capsule comprised copper with a gold coating approximately 0.0063 cm (25 microns) thick on the inner diameter, and had an outer diameter of about 1.27 cm (0.5 inches) and a height of about 3.302 cm (1.3 inches). About 0.91 g of ammonia was added to the capsule. The capsule was then sealed by pressing a gold-coated copper plug into the open end of the capsule.

The sealed capsule was then placed in an apparatus similar to that shown in Figure 1. The sealed capsule was inserted into a cell within the die. NaCl pressure transmission medium; a 3-layer foil heater tube, comprising graphite foil, Mo foil, and Ta foil; dual type K thermocouples; steel end caps; and gasketing were also positioned within the die. Two pairs of thermocouple wires, enclosed in an alumina tube, passed through a hole in the center of the bottom anvil and through a hole in the bottom steel end cap. The bare wires then passed through small-bore holes in the NaCl pressure transmission medium. One thermocouple junction, or bead, was positioned at the bottom of the copper capsule and a second thermocouple junction was positioned along the outer capsule diameter near the top of the capsule. The bottom end cap was fabricated from mild steel and the upper end cap was fabricated from stainless steel. The lower outer diameter of the upper end cap had a 45° bevel and was fitted with a brass ring for an improved seal against the die wall. The outer diameter of the lower end cap was separated from the die wall by a pyrophyllite sleeve. A copper gasket separating the top anvil from the top plane of the die and the top end cap provided electrical contact and distribution of the load. The bottom end cap was in direct contact with the lower anvil. A Mylar gasket separated the bottom of the die from the bottom anvil. The heater tube was separated from the die wall by a salt bushing. Graphite powder was blended with NaCl, isopressed, and machined in order to fabricate the bushing. In order to reduce friction during removal of the cell at the conclusion of the run, the outer diameter of the black salt bushing was separated from the die wall by a 0.00508 cm (0.002 inch) thick Pb foil.

The capsule was heated to a temperature of approximately 800°C by passing current through the heater tube. The capsule was held at temperature for about 16 hours and then cooled. The cell was then pressed out of the die and the pressure transmission medium was dissolved in water. In order to reduce the vapor pressure of ammonia, the capsule was chilled in a dry ice/acetone bath and then punctured with an aw1. Upon warming, the ammonia escaped from the capsule. The resulting weight loss due to the escape of ammonia was about 0.87g, which corresponded to the weight of ammonia still present in the capsule at the end of the run. The near equality of the weights of ammonia before and after the run indicates that the capsule did not burst or leak significantly during the run, thus enabling the AIN powder to be processed in supercritical ammonia in the presence of dissolved NH₄F at a temperature of 800°C.

Based on the phase diagram of supercritical ammonia, at a temperature of 800°C and the fraction (70%) of free volume in the capsule filled by ammonia, the pressure generated within the capsule at 800°C, assuming Born-Haber equilibrium but neglecting the effect of dissolved solutes, was about 10 kbar.

While typical embodiments have been set forth for the purpose of illustration, the foregoing description should not be deemed to be a limitation on the scope of the invention. For example, the pressure vessel disclosed herein may be used to form single crystals of materials other than aluminum nitride.

## Claims

1. A pressure vessel (10) for processing at least one material in a supercritical fluid, said pressure vessel (10) comprising:
(a) a capsule (12) for containing said at least one material and said supercritical fluid in a substantially air-free environment, said capsule (12) being self-pressurizing;
(b) a pressure transmission medium (14) for maintaining an outer pressure on said capsule (12), said pressure transmission medium (14) surrounding said capsule (12);
(c) a heating system for heating said capsule (12), said heating system comprising at least one heating element (18) insertable in said pressure transmission medium (14) such that said at least one heating element (13) is proximate to said capsule (12) and a wattage control system (16) electrically coupled to said at least one heating element (18), wherein said wattage control system (16) provides power to said at least one heating element (18);
(d) a restraint (24) to contain and hold in place said capsule (12), said pressure transmission medium (14), and said at least one heating element (18), wherein said restraint (24) maintains said capsule (12), said pressure transmission medium (14), and said at least one heating element (18) at a constant pressure; and
(e) at least one seal (120,122) for preventing escape of said pressure transmission medium, said at least one seal (120,122) being disposed between said restraint (24) and said pressure transmission medium (14).

2. The pressure vessel (10) of Claim 1, wherein said heating system further corrprises at least one temperature sensor (20) disposed proximate to said capsule (12) for measuring a temperature of said capsule (12).

3. The pressure vessel (10) of Claim 1, wherein said capsule (12) is formed from a malleable metal, and wherein said capsule (12) has a low hydrogen permeability.

4. A pressure vessel (10) of claim 1, the capsule 12 of the pressure vessel (10) further comprising at least one wall (52), a closed end (58), and a sealed enc (56) defining a chamber (54) therein for containing said at least one material and said supercritical fluid, and wherein said heating system comprises at least one temperature sensor (20) disposed proximate to said capsule (12) for measuring a temperature of said capsule (12), the wattage control system (16) being electrically connected to said at least one heating element (13) and said at least one temperature sensor (20).

5. The pressure vessel (10) of Claim 4, wherein said at least one heating element (13) is an electrically resistant heating element (18) comprising one of at least une foil, at least one tube, at least one ribbon, at least one bar, and at least one wire, and combinations thereof.

6. A method of processing at least one material at high temperature and high pressure in the presence of a supercritical fluid, the method comprising the steps of:
(a) providing a sealed capsule (12) containing the at least one material and a solvent that forms a supercritical fluid, wherein the capsule (12) is seff-pressucizing;
(b) providing a pressure vessel (10) comprising a restraint (24), a pressure transmission medium (14) disposed within the restraint (24), and at least one heating element (18) disposed within the restraint (24);
(c) disposing the sealed capsule (12) within the pressure transmission medium (14) such that the sealed capsule (12) is proximate to the at least one heating element (18);
(d) heating the sealed capsule (12) to a predetermined temperature by providing electrical power to the at least one heating element (18), wherein the solvent contained within the sealed capsule (12) becomes a supercritical fluid and wherein the supercritical fluid generates a predetermined pressure within the sealed capsule (12); and
(e) counterbalancing the predetermined pressure within the sealed capsule (12) by applying a pressure to the restraint (24), wherein the at least one material reacts with the supercritical fluid within the sealed capsule (12).

7. The method of claim 6 wherein the at least one heating element is electrically coupled to a wattage control system (16); the method comprising the further steps of:
placing the pressure vessel (10) containing the pressure transmission medium (14), the sealed capsule (12), and the at least one heating element in a press;
pressurizing the press to apply a predetermined pressure to the pressure vessel (10), the pressure transmission medium (14), the sealed capsule (12) and the at least one heating element (18); and
wherein step (d) is further comprised of the step of providing electrical power from the wattage control system (16) to the at least one heating element (18); and wherein in step (e) pressure is applied by maintaining an equivalent pressure with the restraint (24) and transmitting the equivalent pressure through the pressure transmission medium (14).

8. The method of Claim 7, wherein the restraint (24) comprises at least one die, (104) at least one punch, (100, 102) and a hydraulic press, and wherein the pressure transmission medium (14) and the at least one heating element (19) are disposed within the die (104); and wherein the step of disposing the sealed capsule (12) within the pressure vessel (10) comprises disposing the sealed capsule (12) within the die (104) such that the sealed capsule (12) is proximate to the at least one heating element (18).

9. A method for making a metal nitride single crystal comprising the steps of enclosing a metal nitride source material and a solvent within a sealed capsule (12) that is self-pressurizing; disposing the sealed capsule (12) within a pressure vessel (10) comprising a restraint (24), a pressure transmission medium (14) disposed within the restraint (24), and at least one heating element (13) disposed within the restraint (24); heating the sealed capsule (12) to a predetermined temperature, wherein the solvent contained within the sealed capsule (12) becomes a supercritical fluid and generates a predetermined pressure within the sealed capsule (12); and counterbalancing the predetermined pressure within the sealed capsule (12) by applying a pressure tc the restraint (24); wherein the metal nitride source material reacts with the supercritical fluid within the sealed capsule (12) to form a metal nitride single crystal at high temperature and high pressure.

## Patentansprüche

1. Druckbehälter (10) zum Bearbeiten wenigstens eines Materials in einem superkritischen Fluid, wobei der Druckbehälter (10) aufweist:
(a) eine Kapsel (12) zum Aufnehmen des wenigstens eines Materials und des superkritischen Fluids in einer im Wesentlichen luftfreien Umgebung, wobei die Kapsel (12) sich selbst unter Druck setzt;
(b) ein Druckübertragungsmedium (14), um einen Außendruck auf die Kapsel (12) aufrechtzuerhalten, wobei das Druckübertragungsmedium (14) die Kapsel (12) umgibt;
(c) ein Heizsystem zum Aufheizen der Kapsel (12), wobei das Heizsystem wenigstens ein Heizelement (18), das in das Druckübertragungsmedium (14) so einführbar ist, dass das wenigstens eine Heizelement (18) unmittelbar an der Kapsel (12) liegt, und ein Leistungssteuersystem (16), das elektrisch mit dem wenigstens einem Heizelement (18) verbunden ist, aufweist, wobei das Leistungssteuersystem (16) Energie an das wenigstens eine Heizelement (18) liefert;
(d) eine Halteeinrichtung (24), um die Kapsel (12), das Druckübertragungsmedium (14) und das wenigstens eine Heizelement (18) aufzunehmen und an ihrem Platz zu halten, wobei die Halteeinrichtung (24) die Kapsel (12), das Druckübertragungsmedium (14) und das wenigstens eine Heizelement (18) auf einem konstanten Druck hält; und
(e) wenigstens eine Verschlussvorrichtung (120, 122), um ein Entweichen des Druckübertragungsmediums zu verhindern, wobei die wenigstens eine Verschlussvorrichtung (120, 122) zwischen der Halteeinrichtung (24) und dem Druckübertragungsmedium (14) angeordnet ist.

2. Druckbehälter (10) nach Anspruch 1, wobei das Heizsystem ferner wenigstens einen Temperatursensor (20) aufweist, der unmittelbar an der Kapsel (12) zum Messen einer Temperatur der Kapsel (12) angeordnet ist.

3. Druckbehälter (10) nach Anspruch 1, wobei die Kapsel (12) aus einem schmiedbaren Metall ausgebildet ist und wobei die Kapsel (12) eine geringe Wasserstoffdurchlässigkeit aufweist.

4. Druckbehälter (10) nach Anspruch 1, wobei die Kapsel (12) des Druckbehälters (10) ferner wenigstens eine Wand (52), ein abgeschlossenes Ende (58) und ein dicht verschlossenes Ende (56) aufweist, die darin eine Kammer (54) für die Aufnahme des wenigstens einen Materials und des superkritischen Fluids definieren, und wobei das Heizsystem wenigstens einen Temperatursensor (20) aufweist, der zum Messen einer Temperatur der Kapsel (12) unmittelbar an der Kapsel (12) angeordnet ist, und wobei das Leistungssteuerungssystem (16) elektrisch mit dem wenigstens einen Heizelement (18) und dem wenigstens einem Temperatursensor (20) verbunden ist.

5. Druckbehälter (10) nach Anspruch 4, wobei das wenigstens eine Heizelement (18) ein elektrisches Widerstandsheizelement (18) ist, das wenigstens eine Folie, wenigstens ein Rohr, wenigstens ein Band, wenigstens eine Stange und wenigstens einen Draht und Kombinationen davon aufweist.

6. Verfahren zum Bearbeiten wenigstens eines Materials bei hoher Temperatur und hohem Druck bei Vorhandensein eines superkritischen Fluids, wobei das Verfahren die Schritte aufweist:
(a) Bereitstellen einer dicht verschlossenen Kapsel (12), welche das wenigstens eine Material und ein Lösungsmittel enthält, das ein superkritisches Fluid erzeugt, wobei die Kapsel (12) sich selbst unter Druck setzt;
(b) Bereitstellen eines Druckbehälters (10) mit einer Halteeinrichtung (24), einem Druckübertragungsmedium (14), das in der Halteeinrichtung (24) angeordnet ist, und wenigstens einem Heizelementes (18), das in der Halteeinrichtung (24) angeordnet ist;
(c) Anordnen der dicht verschlossenen Kapsel (12) in dem Druckübertragungsmedium (14) so, dass sich die dicht verschlossene Kapsel (12) unmittelbar an dem wenigstens einem Heizelement (18) befindet;
(d) Aufheizen der dicht verschlossenen Kapsel (12) auf eine vorbestimmte Temperatur durch Zuführen von elektrischer Energie an das wenigstens eine Heizelement (18), wobei das in der dicht verschlossenen Kapsel (12) enthaltene Lösungsmittel zu einem superkritischen Fluid wird, und wobei das superkritische Fluid einen vorbestimmten Druck in der dicht verschlossenen Kapsel (12) erzeugt; und
(e) Kompensieren des vorbestimmten Druckes in der dicht verschlossenen Kapsel (12) durch Aufbringen eines Druckes auf die Halteeinrichtung (24), wobei das wenigstens eine Material mit dem superkritischen Fluid in der dicht verschlossenen Kapsel (12) reagiert.

7. Verfahren nach Anspruch 6, wobei das wenigstens eine Heizelement elektrisch mit einem Leistungssteuersystem (16) verbunden ist; wobei das Verfahren ferner die Schritte aufweist:
Platzieren des das Druckübertragungsmedium (14), die dicht verschlossene Kapsel (12) und das wenigstens eine Heizelement enthaltenden Druckbehälters (2) in einer Presse;
Betätigen der Presse, um einen vorbestimmten Druck auf den Druckbehälter (10), das Druckübertragungsmedium (14), die dicht verschlossene Kapsel (12) und das wenigstens eine Heizelement (18) aufzubringen; und
wobei der Schritt (d) ferner den Schritt der Lieferung elektrischer Energie aus dem Leistungssteuersystem (16) an das wenigstens eine Heizelement (18) umfasst; und wobei im Schritt (e) Druck aufgebracht wird, indem ein äquivalenter Druck mit der Halteeinrichtung (24) aufrechterhalten wird, und der äquivalente Druck über das Druckübertragungsmedium (14) übertragen wird.

8. Verfahren nach Anspruch 7, wobei die Halteeinrichtung (24) wenigstens ein Gesenk (104), wenigstens einen Stempel (100, 102) und eine hydraulische Presse aufweist, und wobei das Druckübertragungsmedium (14) und das wenigstens eine Heizelement (18) in dem Gesenk (104) angeordnet sind; und wobei der Schritt der Anordnung der dicht verschlossenen Kapsel (12) in dem Druckbehälter (10) die Anordnung der dicht verschlossenen Kapsel (12) in dem Gesenk (104) in der Weise umfasst, dass die dicht verschlossene Kapsel (12) unmittelbar an dem wenigstens einen Heizelement (18) liegt.

9. Verfahren zum Erzeugen eines Metallnitrid-Einkristalls mit den Schritten: Einschließen eines Metallnitrid-Quellenmaterials und eines Lösungsmittels in einer dicht verschlossenen Kapsel (12), die sich selbst unter Druck setzt; Anordnen der dicht verschlossenen Kapsel (12) in einem Druckbehälter (10), der eine Halteeinrichtung (24), ein in der Halteeinrichtung (24) angeordnetes Druckübertragungsmedium (14) und wenigstens ein in der Halteeinrichtung (24) angeordnetes Heizelement (13) enthält; Aufheizen der dicht verschlossenen Kapsel (12) auf eine vorbestimmte Temperatur, wobei das in der dicht verschlossenen Kapsel (12) enthaltene Lösungsmittel zu einem superkritischen Fluid wird und einen vorbestimmten Druck in der dicht verschlossenen Kapsel (12) erzeugt; und Kompensieren des vorbestimmten Druckes in der dicht verschlossenen Kapsel (12) durch Aufbringen eines Druckes auf die Halteeinrichtung (24); wobei das Metallnitrid-Quellenmaterial mit dem superkritischen Fluid in der dicht verschlossenen Kapsel (12) reagiert, um einen Metallnitrid-Einkristall bei hoher Temperatur und hohem Druck zu erzeugen.

## Revendications

1. Cuve à pression (10) pour le traitement d'au moins un matériau dans un fluide supercritique, ladite cuve (10) comprenant :
(a) une capsule (12) pour contenir ledit matériau et ledit fluide supercritique dans une enceinte substantiellement exempte d'air, ladite capsule (12) étant auto-pressurisante ;
(b) un milieu transmetteur de pression (14) pour maintenir une pression externe sur ladite capsule (12), ledit milieu transmetteur de pression (14) entourant ladite capsule (12) ;
(c) un système de chauffage pour chauffer ladite capsule (12), ledit système de chauffage comprenant au moins un élément de chauffage (18) pouvant être immergé dans ledit milieu transmetteur de pression (14) de sorte que ledit au moins un élément de chauffage (18) est à proximité immédiate de ladite capsule (12) et un système de commande de puissance électrique (16) couplé électriquement au dit au moins un élément de chauffage (18), ledit système de commande de puissance électrique (16) fournissant l'énergie audit au moins élément de chauffage (18) ;
(d) un système de confinement (24) pour recevoir et maintenir en place ladite capsule (12), ledit milieu transmetteur de pression (14) et ledit au moins un élément de chauffage (18, ledit système de confinement (24) maintenant ladite capsule (12), ledit milieu transmetteur de pression (14) et ledit au moins un élément de chauffage (18) sous une pression constante ; et
(e) au moins un joint d'étanchéité (120, 122) pour éviter une fuite dudit milieu transmetteur de pression, ledit au moins un joint (120, 122) étant positionné entre ledit système de confinement (24) et ledit milieu transmetteur de pression (14).

2. Cuve à pression (10) selon la revendication 1, dans laquelle ledit système de chauffage comprend en outre au moins une sonde de température (20) placée dans le voisinage immédiat de ladite capsule (12) pour permettre de mesurer la température de ladite capsule (12).

3. Cuve à pression (10) selon la revendication 1 dans laquelle ladite capsule (12) est façonnée dans un métal malléable et présente une faible perméabilité à l'hydrogène.

4. Cuve à pression (10) selon la revendication 1, la capsule 12 de l'appareil à pression (10) comprenant en outre au moins une paroi (52), une extrémité fermée (58) et une extrémité hermétique (56) délimitant ainsi une chambre (54) pour contenir ledit au moins un matériau et ledit fluide supercritique, et dans lequel ledit système de chauffage comprend au moins une sonde de température (20) placée au voisinage immédiat de ladite capsule (12) pour pouvoir mesurer la température de ladite capsule (12), le système de commande de puissance électrique (16) étant relié électriquement audit au moins un élément de chauffage (18) et à ladite au moins une sonde de température (20).

5. Cuve à pression (10) selon la revendication 4, dans laquelle ledit au moins un élément de chauffage (18) est un élément de chauffage par résistance électrique (18) comprenant un élément parmi au moins une feuille, un tube, un ruban, un barreau et un câble, et des combinaisons de ces derniers.

6. Procédé pour traiter au moins un matériau à haute température et à haute pression en présence d'un fluide supercritique, le procédé comprenant les étapes suivantes :
(a) fourniture d'une capsule hermétique (12) contenant au moins un matériau et un solvant constituant le fluide supercritique, la capsule (12) étant auto-pressurisante ;
(b) fourniture d'une capsule hermétique (12) comprenant un système de confinement (24), un milieu transmetteur de pression (14) placé dans le système de confinement (24) et au moins un élément de chauffage (18) placés dans le système de confinement (24).
(c) mise en place de la capsule hermétique (12) dans le milieu transmetteur de pression (14) de sorte que la capsule hermétique (12) est au voisinage immédiat dudit au moins élément de chauffage (18) ;
(d) chauffage de la capsule hermétique (12) à une température préétablie en fournissant de la puissance électrique audit au moins un élément de chauffage (18), ce par quoi le solvant contenu dans la capsule hermétique (12) devient un fluide supercritique et le fluide supercritique génère une pression préétablie dans la capsule hermétique (12) ; et
(e) équilibrage de la pression préétablie dans la capsule hermétique (12) en appliquant une pression dans le système de confinement (24), à la suite de quoi le matériau minimum réagit avec le fluide supercritique au sein de la capsule hermétique (12).

7. Procédé selon la revendication 6 dans lequel ledit au moins un élément de chauffage est couplé électriquement au système de commande de puissance électrique (16) ;
le procédé comprenant les étapes ultérieures suivantes :
mise en place de la cuve à pression (10) contenant le milieu transmetteur de pression (14), la capsule hermétique (12) et au moins un élément de chauffage dans une presse ;
pressurisation de la presse pour appliquer une pression préétablie à la cuve à pression (10), au milieu transmetteur de pression (14), à la capsule hermétique (12) et audit au moins un élément de chauffage (18) ; et
dans lequel l'étape (d) comprend en outre l'étape d'alimentation électrique de l'élément de chauffage minimum (18) à partir du système de commande de puissance électrique (16), et dans lequel la pression à l'étape (e) est appliquée en maintenant une pression équivalente avec le système de confinement (24) et en transmettant la pression équivalente au moyen du milieu transmetteur de pression (14).

8. Procédé selon la revendication 7, dans lequel le système de confinement (24) comprend au moins une matrice (104), un poinçon, (100, 102) et une presse hydraulique, dans lequel le milieu transmetteur de pression (14) et ledit au moins un élément de chauffage (18) sont placés dans la matrice (104), et dans lequel l'étape de mise en place de la capsule hermétique (12) dans l'appareil à pression (10) comprend la mise en place de la capsule hermétique (12) dans la matrice (10) de manière à ce que la capsule hermétique (12) soit au voisinage immédiat dudit au moins un élément de chauffage (18).

9. Procédé pour fabriquer un monocristal de nitrure métallique comprenant les étapes consistant à enfermer un matériau source de nitrure métallique et un solvant dans une capsule hermétique (12) auto-pressurisante, à placer la capsule hermétique (12) dans une cuve à pression (10) pourvue d'un système de confinement (24), un milieu transmetteur de pression (14) mis dans le système de confinement (24) et au moins un élément de chauffage (18) placé dans le système de confinement (24), à chauffer la capsule hermétique (12) à une température préétablie à laquelle le solvant renfermé dans la capsule hermétique (12) devient un fluide supercritique, génère une pression prédéterminée dans la capsule hermétique (12) et contrebalance la pression préétablie dans la capsule hermétique (12) en appliquant une pression dans le système de confinement (24), dans laquelle le matériau source de nitrure métallique réagit en présence du fluide supercritique dans la capsule hermétique (12) pour former, à haute température et à haute pression, un monocristal de nitrure métallique.
